# EUROPEAN PATENT APPLICATION

(11) **EP 4 810 885 A1**
(43) Date of publication of application: **23.09.2026**
(21) Application number: 26164642.6
(22) Date of filing: 13.03.2026
(51) Int. Cl.: F27B 9/30, B23K 1/008, B23K 3/08, F24C 15/14, F27D 3/00, H05K 3/34

(54) **FRAME AND REFLOW OVEN**

(30) Priority: 20.03.2025 CN 202520498908 U
(71) Applicant: Illinois Tool Works Inc., Glenview IL 60025 (US)
(72) Inventor: WANG, Chuanbo, Glenview, 60025 (US)
(74) Representative: HGF

(57) **Abstract**

The present disclosure discloses a frame and a reflow oven. The frame comprises a base (102) and at least one support mechanism (104). The support mechanism (104) is disposed on the base (102). The support mechanism (104) comprises support assemblies (201). The support assembly (201) comprises a first support member (221) connected to the base (102) and a second support member (222) detachably connected to first support member (221). The second support member (222) is movable relative to the first support member (221) so as to be separated from the first support member (221). The frame of the present disclosure is easy to be disassembled and easy to clean the width-adjustment assembly.

## Description

### Technical Field

The present disclosure relates to a field of frames and, more particularly, to a field of frames of reflow ovens.

### Background

Existing reflow ovens are used to heat components to be heated. The atmosphere gas within the reflow ovens contains solder paste dissolved therein. The solder paste then adheres to the width-adjustment assembly, causing its adjustment to become unsmooth. Consequently, existing width-adjustment assemblies require periodic cleaning.

### Summary

Through in-depth research, the inventor of the present disclosure has found that the structure of reflow ovens in the prior art is complex, requiring the disassembly of many components for cleaning, which makes the operation troublesome.

To solve the above technical problem, the present disclosure provides a frame for a reflow oven, which comprises a base and at least one support mechanism disposed on the base. The support mechanism comprises support assemblies. The support assemblies comprise a first support member connected to the base and a second support member detachably connected to the first support member. The second support member is movable relative to the first support member so as to be separated from the first support member.

According to some embodiments, the support assemblies also comprise connecting members configured to detachably connect the first support member and the second support member.

According to some embodiments, the support assemblies also comprise an insert member insertable into one of the first support member and the second support member and configured to move another one of the first support member and the second support member to separate the first support member from the second support member. The insert member can drive the first support member or the second support member to move along a first direction.

According to some embodiments, the first support member is provided with a through hole, the insert member insertable into the through hole and being configured to abut against the second support member to separate the first support member from the second support member.

According to some embodiments, the second support member is provided with an abutting wall substantially perpendicular to a first direction. The insert member can abut against the abutting wall to separate the first support member from the second support member.

According to some embodiments, the insert member is configured to adjust the distance between the first support member and the second support member along the first direction.

According to some embodiments, the through hole is provided with an internal thread on the inner wall. The insert member is provided with an external thread for mating with the internal thread.

According to some embodiments, the support assemblies also comprise a guide member and a maintaining member. The guide member is connected to the two first support members of the support assemblies. The maintaining member is connected to the two second support members of the support assemblies.

According to some embodiments, the frame also comprises a first guide rail and a second guide rail. The first guide rail forms by extending along a first direction. The second guide rail forms by extending along the first direction. The first guide rail and the second guide rail are connected to the guide member and are disposed between the guide member and the maintaining member.

In another aspect, the present disclosure discloses a reflow oven comprising a frame according to the present disclosure.

Compared with the prior art, the frame provided in the present disclosure can be used in a reflow oven, is easy to disassemble, and facilitates cleaning of the width-adjustment assembly. Specifically, the first support member and the second support member are detachably connected. When the width-adjustment assembly needs to be cleaned, an operator unscrews the connecting members, thereby separating the first support member from the second support member. As a result, the width-adjustment assembly connected to the second support member can be separated together with the second support member from the first support member, thus facilitating cleaning by the operator.

### Brief Description for The Drawings

The features and advantages of the present disclosure can be better understood by reading the following detailed description with reference to the accompanying drawings. Throughout the drawings, the same reference numerals represent the same components, in which:
FIG. 1 is a partial perspective view of a frame applicable for a reflow oven according to the present application;
FIG. 2 is a perspective view of the support mechanism shown in FIG. 1;
FIG. 3 is a perspective view of the support assembly shown in FIG. 2.

### Description of the Main Reference Numerals

102 base; 104 support mechanism; 111 first guide rail; 112 second guide rail; 201 support assembly; 202 guide member; 203 maintaining member; 211 width-adjustment assembly; 221 first support member; 222 second support member; 311 first main body; 312 first head; 313 second main body; 314 second head; 321 first head top surface; 322 first head side surface; 323 first main body top surface; 324 second main body bottom surface; 325 abutting wall; 326 second head bottom surface; 331 connecting member; 332 connecting through hole; 333 connecting hole; insert member; 342 through hole.

### Detailed Description

Various specific embodiments of the present application will now be described with reference to the accompanying drawings, which form a part of this specification. It should be understood that, in the following drawings, the same components are denoted by the same reference numerals.

Various specific embodiments of the present application will now be described with reference to the accompanying drawings, which form a part of this specification. It should be understood that, although directional terms such as "upper," "lower," "left," "right," "inner," "outer," and the like are used in this application to describe various exemplary structural parts and elements of the present application, these terms are used herein only for the purpose of convenience of explanation and are based on the exemplary orientations shown in the drawings. Since the embodiments disclosed in the present application can be arranged in different orientations, these directional terms are for illustration only and should not be construed as limiting.

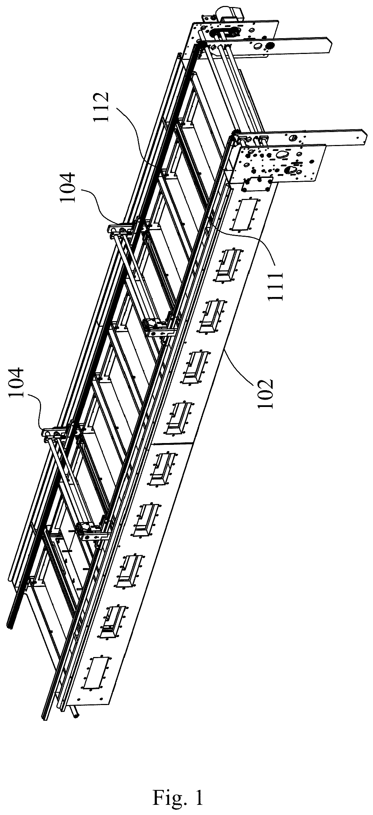

FIG. 1 is a partial perspective view of a frame applicable for a reflow oven according to the present application. As illustrated in Fig. 1, the frame includes a base 102, two support mechanisms 104, a first guide rail 111 and a second guide rail 112. The base 102 has an accommodating portion opened upward for receiving heating components (not shown). The two support mechanisms 104 are disposed on the base 102 and spaced apart from each other along a first direction (i.e., the length direction of the base 102). The two support mechanisms 104 support the first guide rail 111 and the second guide rail 112 extending along the first direction. It should be understood that at least one support mechanism 104 is within the scope of the present disclosure although two support mechanisms 104 are illustrated in the figure of the present disclosure.

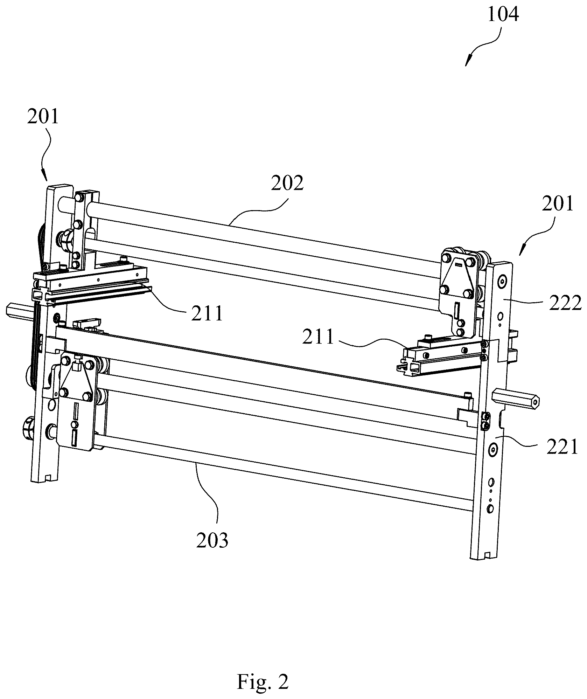

Figure 2 is a perspective view of the support mechanism 104 shown in FIG. 1, showing the detailed structure of the support mechanism 104. As shown in Fig.2, the support mechanism 104 includes a pair of support assemblies 201, a guide member 202, a maintaining member 203 and a pair of width-adjustment assemblies 211. The pair of support assemblies 201 are spared apart from each other by a distance along a second direction (i.e., the width direction of the base 102). The guide member 202 forms by extending along the second direction and connects the pair of support assemblies 201. In the present disclosure, the guide member 202 is a screw rod and connects to the upper portions of the pair of the support assemblies 201. The pair of width-adjustment assemblies 211 are disposed on the guide member 202 for supporting the firs guide rail and the second guide rail. The width-adjustment assemblies 211 are movable along the second direction relative to the guide member 202 so as to adjust the distance between the firs guide rail and the second guide rai, thereby accommodating components to be heated of different widths. The maintaining member 203 forms by extending along the second direction and connects the pair of support assemblies 201, maintaining the parallelism of the pair of support assemblies 201. In the present disclosure, the maintaining member 203 is a shaft and connects to the lower portions of pair of support assemblies 201. The lower portion of the support mechanism 104 is accommodated in the base and the heating components (not shown) are disposed between the width-adjustment assemblies 211 and the maintaining member 203 when the support mechanism 104 is disposed on the base. It should be understood that one support assembly 201 is also within the scope of the present disclosure although a pair of support assemblies 201 are shown in the figure of the present disclosure.

As shown in Fig.2, the support assembly 201 includes a first support member 221 and a second support member 222. The first support member 221 is disposed below the second support member 222. The maintaining member 203 connects the two first support members 221. The guide member 202 connects the two second support members 222. The first support members 221 are used to connect to the base. The second support member 222 is detachably connected to the first support member 221. More specifically, the second support member 222 is movable relative to the first support member 221 so as to be separated from the first support member 221. Accordingly, an operator can remove the components (e.g.,the guide member 202 and the width-adjustment assembly 211) connected with the second support member 222 together with the second support member 222 to clean these components.

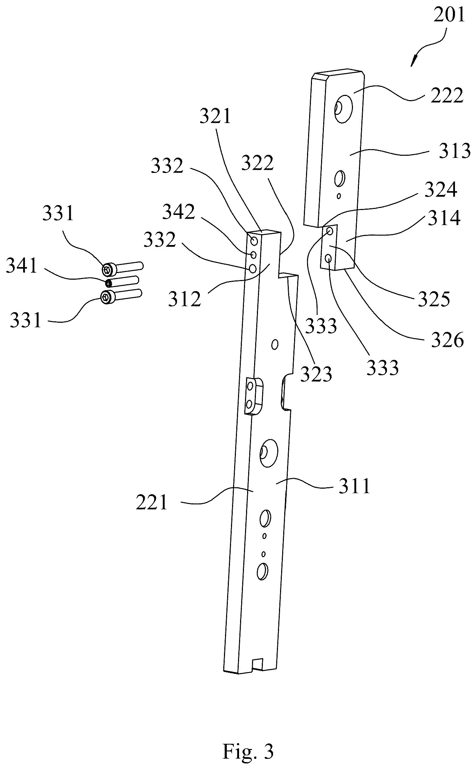

Fig. 3 is a perspective view of the support assembly 201 shown in Fig. 2, which shows the detailed structure of the support assembly 201. As shown in Fig.3, the first support member 221 includes a first main body 311 and a first head 312. The first main body 311 forms by extending along a third direction (i.e., the height direction of the base). The first main body 311 includes a first main body top surface 323. The first head 312 extends upwardly from a portion of the first main body top surface 323. The first head 312 includes a first head top surface 321 and a first head side surface 322. The first main body top surface 323, the first head top surface 321 and the first head side surface 322 form a first step portion, and the shapes of the first main body top surface 323, the first head top surface 321 and the first head side surface 322 mate with the second support member 222.

As shown in Fig. 3, the second support member 222 includes a second main body 313 and a second head 314. The second main body 313 forms by extending along the third direction (i.e., the height direction of the base). The second main body 313 includes a second main body bottom surface 324. The second head 314 extends downwardly from a portion of the second main body bottom surface 324. The second head 314 includes an abutting wall 325 and a second head bottom surface 326. The second main body bottom surface 324,the abutting wall 325 and the second head bottom surface 326 form a second step portion, and the shapes of the second main body bottom surface 324, the abutting wall 325 and the second head bottom surface 326 mate with the firs step portion of the first support member 221. The abutting wall 325 is substantially perpendicular to the first direction.

Therefore, the first support member 221 and the second support member 222 form a reliable abutting structure to connect the first support member 221 and the second support member 222 when the first step portion and the second step portion cooperate with each other (namely, the first head top surface 321 abuts against the second main body bottom surface 324, the first head side surface 322 abuts against the abutting wall 325 and the first main body top surface 323 abuts against the second head bottom surface 326).

As shown in Fig. 3, the support assembly 201 also includes two connecting members 331. The connecting members 331 are configured to detachably connects the first support member 221 and the second support member 222. The connecting members 331 are provided with an external thread. Specifically, the first head 312 is provided with two connecting through holes 332 penetrating along the first direction. The second head 314 is correspondingly provided with two connecting holes 333 extending along the first direction. The connecting through holes 332 and the connecting holes 333 are both provided with an internal tread on their inner walls for mating with the external tread. Hence, the connecting members 331 can be inserted into the connecting through holes 332 and the connecting holes 333 and connects the first support member 221 and the second support member 222. When it is necessary to separate the first support member 221 from the second support member 222, the operator can unscrew the connecting members 331 to achieve the separation.

As shown in Fig. 3, the support assembly 201 also includes an insert member 341. The insert member 341 helps separate the first support member 221 from the second support member 222. Specifically, the insert member 341 is provide with an external thread. The first head 312 is provided with a through hole 342 penetrating along the first direction. The through hole 342 is provided with an internal thread on its inner wall for mating with the external thread. The insert member 341 can be inserted into the through hole 342 and abuts against the abutting wall 325 of the second head 314 so as to help separate the first support member 221 from the second support member 222 along the first direction.

In addition, since the first head 312 is provided with the through hole 342 penetrating along the first direction and the through hole 342 is provided with the internal thread on its inner wall for mating with the external thread, when the first support member 221 and the second support member 222 are connected to each other, the operator can adjust the gap between the first support member 221 and the second support member 222 (i.e., the distance between the first head side surface 322 and the abutting wall 325) through the insert member 341 so as to adjust the distance between the first support member 221 and the second support member 222 along the first direction.

It should be understood that, although the present disclosure shows that the insert member 341 is inserted in the first support member 221 and abuts against the second support member 222, in other examples, the insert member 341 is inserted in the second support member 222 and abuts against the first support member 221, which is also within the scope of the present disclosure.

It also should be understood that, although the present disclosure shows that the first support member 221 is provided with the first step portion and the second support member 222 is provided with the mating second step portion, all of the first support members 221 and second support members 222 that are capable of mating with each other are within the protection scope of the present disclosure.

It further should be understood that, although the connecting members 331 and the insert member 341 in the present disclosure move along the first direction to connect and separate the first support member 221 and the second support member 222, the connecting members 331 and/or the insert member 341 can also move along the second direction.

In the prior art, since the atmosphere gas in the reflow oven contains dissolved solder paste, the solder paste adheres to the width-adjustment assembly, thereby causing the width-adjustment assembly to move unsmoothly relative to the guide member. Therefore, the existing width-adjustment assembly requires periodic cleaning. The inventors of the present disclosure have discovered that, because the heating components are disposed between the connecting members and the guide member, an operator needs to remove the heating components from the base before cleaning the width-adjustment assembly, which is troublesome.

The frame for a reflow oven of the present disclosure is easy to disassemble, facilitating cleaning of the width-adjustment assembly. Specifically, the first support member and the second support member are detachably connected. When the width-adjustment assembly needs to be cleaned, an operator unscrews the connecting members, thereby separating the first support member from the second support member. As a result, the width-adjustment assembly, which is connected to the second support member, can be separated together with the second support member from the first support member, thus facilitating cleaning by the operator.

In addition, the first rail and the second rail of the reflow oven of the present disclosure can have high parallelism. Specifically, the insert member can adjust the distance between the first support member and the second support member, thereby adjusting the parallelism of the first rail and the second rail.

Although the present disclosure has been described in conjunction with examples of the embodiments outlined above, various alternatives, modifications, variations, improvements, and/or substantial equivalents, whether known or now or hereafter foreseeable, may be apparent to those having at least ordinary skill in the art. Furthermore, the technical effects and/or technical problems described in this specification are exemplary and not restrictive; thus, the disclosure in this specification may be applied to solve other technical problems and may have other technical effects and/or may solve other technical problems. Accordingly, the examples of the embodiments of the present disclosure set forth above are intended to be illustrative, not limiting. Various changes may be made without departing from the spirit or scope of the present disclosure. Therefore, the present disclosure is intended to embrace all known or earlier developed alternatives, modifications, variations, improvements, and/or substantial equivalents.

## Claims

1. A frame for a reflow oven, **characterized by** comprising:
base (102); and
at least one support mechanism (104) disposed on the base (102);
wherein the support mechanism (104) comprises support assemblies (201), the support assemblies (201) comprising:
a first support member (221) connected to the base (102); and
a second support member (222) detachably connected to the first support member (221);
wherein the second support member (222) is movable relative to the first support member (221) so as to be separated from the first support member (221).

2. The frame of claim 1, **characterized in that** the support assemblies (201) also comprise connecting members (331) configured to detachably connect the first support member (221) and the second support member (222).

3. The frame of claim 1, **characterized in that** the support assemblies (201) also comprise an insert member (341) insertable into one of the first support member (221) and the second support member (222) and configured to move another one of the first support member (221) and the second support member (222) to separate the first support member (221) from the second support member (222).

4. The frame of claim 3, **characterized in that** the first support member (221) is provided with a through hole (342), the insert member (341) insertable into the through hole (342) and being configured to abut against the second support member (222) to separate the first support member (221) from the second support member (222).

5. The frame of claim 3, **characterized in that**
the second support member (222) is provided with an abutting wall (325) substantially perpendicular to a first direction; and
the insert member (341) is configured to abut against the abutting wall (325) to separate the first support member (221) from the second support member (222).

6. The frame of claim 3, **characterized in that**
the insert member (341) is configured to adjust the distance between the first support member (221) and the second support member (222) along the first direction.

7. The frame of claim 4, **characterized in that**
the through hole (342) is provided with an internal thread on the inner wall; and
the insert member (341) is provided with an external thread for mating with the internal thread.

8. The frame of claim 1, **characterized in that** the support assemblies (201) also comprise:
a guide member (202) connected to the two first support members (221) of the support assemblies (201); and
a maintaining member (203) connected to the two second support members (222) of the support assemblies (201).

9. The frame of claim 1, **characterized in that** the frame also comprises:
a first guide rail (111) forming by extending along a first direction; and
a second guide rail (112) forming by extending along the first direction;
wherein the first guide rail (111) and the second guide rail (112) are connected to the guide member (202) and are disposed between the guide member (202) and the maintaining member (203).

10. A reflow oven, **characterized by** comprising a frame of any one of claims 1-9.
